(19) Europäisches Patentamt

European Patent Office

Office européen des brevets

(11) Publication number: 0 274 787
A1

# (12) EUROPEAN PATENT APPLICATION

(21) Application number: 87202481.5

(22) Date of filing: 10.12.87

(51) Int. Cl.⁴: G01R 19/04

(30) Priority: 12.12.86 NL 8603171

(43) Date of publication of application:
20.07.88 Bulletin 88/29

(84) Designated Contracting States:
AT BE CH DE ES FR GB IT LI LU NL SE

(71) Applicant: Staat der Nederlanden
(Staatsbedrijf der Posterijen, Telegrafie en
Telefonie)
P.O. Box 430
NL-2260 AK Leidschendam(NL)

(72) Inventor: Van Arnhem, Willem Cornelis
R. Van Goenstraat 63
NL-2593 EG 's-Gravenhage(NL)
Inventor: Kegel, Jacobus Adrianus
Bruntinger Brink 93
NL-7812 VH Emmen(NL)

(54) Device for delivering an output signal corresponding to the maxima or minima of a variable input signal.

(57) Device for detecting the maxima or minima of a variable input signal, the instantaneous values of the variable input signal (A) and those of the output signal (B) of a signal generator (5) - at the same time the output signal of the device - being compared with each other in a signal comparison device (1). An output terminal (4) of this signal comparison device controls the signal generator in such a way that the instantaneous value of its output signal (B) will either increase (or remain the same), if that of the variable input signal (A) is greater, or decrease (or remain the same), if that of the variable input signal (A) is smaller. If the rate of increase of the output signal is higher than the rate of decrease, the output signal will follow the maxima of the variable input signal, if, on the other hand, the rate of decrease prevails, it will follow the minima. The signal generator is preferably formed by a digital up/down counter (18), the clock frequency of which differs when counting up from that when counting down. The counting-up as well as the counting-down process is, simultaneously with the setting of the relevant clock frequency by means of a clock selection device (13), controlled by the output signal of the signal comparison device. The digital output signals, the value of which will increase (, remain the same) or decrease, are converted into an analog output signal (B) by a DA-converter (20).

FIG. 2

# Device for delivering an output signal corresponding to the maxima or minima of a variable input signal.

## A. Background of the invention

### 1. Field of the invention

The invention relates to a device for delivering an output signal corresponding to the maxima or minima of a variable input signal.

### 2. State of the art

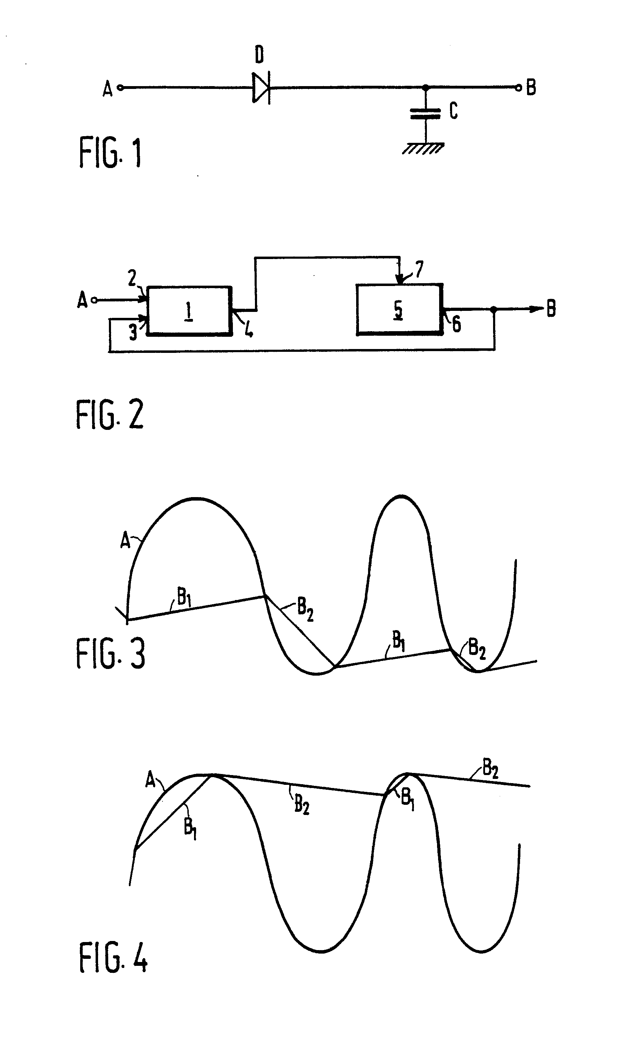

Generally known is a circuit for detecting particularly the maximum values of a variable input signal consisting of a diode and the capacitor as represented in figure 1 and known under the name of "integrator".

It is true that the advantages of the aforesaid circuit are that it is cheap and extremely simple, but it has the drawbacks that it is not well usable at low frequencies, that it is temperature-dependent (the diode is temperature-dependent) and that it does not offer the possiblity to control (e.g. by means of software) the time of charging respectively discharging the capacitor (the "following speed" of the circuit). Moreover, the minimum values of variable signals (e.g. alternating voltage with a direct voltage component) superposed on a constant value cannot be determined by means of this circuit, which, besides, cannot be used in the case of small signals because of the threshold voltage (abt. 0.6 volt) of the diode. Finally the circuit cannot retain the maximum value of the input signal for a (controllably) long time due to the discharging of the capacitor.

## B. Summary of the invention

The object of the invention is to remove the difficulties of the known circuit, and it provides a device for delivering an output signal corresponding to the maxima or minima of a variable input signal, which device can also be used for low frequencies (from 0 Hz), an which offers the possibilities to control the "following speed", to determine the minimum values, also of variable input signals superposed on a constant value, correctly, to process also small signals in the right way, and to retain, if required, maximum or minimum values of the input signal for an unlimited length of time.

Characteristic of the device according to the present invention is a signal comparison device and a signal generator, which delivers said output signal, notably under the control of a control signal, which is taken from an output terminal of the signal comparison device and is a function of the resultant of the comparison of the respective instantaneous values of said variable input signal offered to a first input terminal of the signal comparison device with the output signal of the signal generator fed back to a second input terminal of the signal comparison device, the output signal of the signal generator being formed by a consecutive alternation of a first output signal with an instantaneous value which, as a function of the time, will not decrease at least on an average, if the output signal of the signal generator is smaller than the variable input signal and a second output signal with an instantaneous value which, as a function of the time, will not increase at least on an average, if the output signal of the signal generator is larger than the variable input signal, the average rate at which the first output signal increases as a function of the time being unequal to the average rate at which the second output signal decreases as a function of the time.

Owing to said measures it is achieved that the course of the variable input signal will be compared with the course of the output signal of the signal generator, which will be controlled in such a way that, if and as long as the input signal is larger than the output signal of the signal generator, this (first) output signal will have in the time a constant or an increasing course (on an average). As soon as the output signal is larger than the input signal or the input signal is smaller than said output signal, the control signal delivered by the output terminal of the signal comparison device will cause said signal generator to deliver a second output signal following on the first output signal with in the time a constant or a decreasing course (on an average). As already mentioned the (average) rate at which the first output signal increases as a function of the time should differ from the (average) rate at which the second output signla decreases as a function of the time. This implies that if the first output signal remains constant as a function of the time, the second output signal will have to decrease; likewise it implies that if the second output signal remains constant, the first output signal will have to increase. Owing to this inequality between the rate of increase and the rate of decrease it is effected that the output signal of the signal generator will move as it were in the direction of either the minimum value(s) or the maximum value(s) of the input signal. Whether this movement takes place in the direction of the minima or of the maxima depends on the rate at which the first output signal increases with regard to the rate at which the second output signal decreases. In the case of a relatively high rate of increase the output signal will move towards the maximum; in the case of a relatively high rate of decrease it will move towards the minimum.

After the output signal of the signal generator has reached the minimum or the maximum value, this value will be maintained, if the first respectively the second output signal has a smooth, so a constant course in the time. However, as a rule not a constant, but just a more or less increasing respectively decreasing course will be preferred, so that it will be possible to follow a (trendwise) increasing of the minima respectively decreasing of the maxima, if any, with a certain delay.

The rate of increase of the first output signal and the rate of decrease of the second output signal determine the "following speed" of the device, i.e. the speed at which the output signal of the device, in this case the signal generator, follows the variations in maxima respectively minima of the input signal.

As a preferred embodiment of the invention the signal generator comprises a first clock signal generator for delivering a first clock signal at a first frequency to a first input terminal of a clock selection device, as well as a second clock signal generator for delivering a second clock signal at a second frequency - unequal to said first frequency - to a second input terminal of said clock selection device;

the clock selection device offering, under the control of the output signal of said signal comparison device, either said first clock signal - if the signal at the second input terminal of the signal comparison device is smaller than that at the first input terminal -or said second clock signal - if, on the other hand, the signal at the second input terminal of the signal comparison device is larger than that at the first input terminal - to a clock control terminal of a digital signal generator;

which digital signal generator delivers digital signals at its output terminal at a frequency which is proportionate to the clock signal offered to the clock control terminal, the value of which digital signals will either increase under the control of the output signal of said signal comparison device - if the signal at the second input terminal of the signal comparison device is smaller than that at the first input terminal - or decrease - if, on the other hand, the signal at the second input terminal of the signal comparison device is larger than that at the first input terminal;

the output terminal of which digital signal generator is connected with the second input terminal of the signal comparison device via a DA-converting device.

The rate at which the first output signal of the signal generator increases is determined in said preferred embodiment by the (first) frequency of the first clock signal and the rate at which the second output signal of the signal generator decreases by the (second) frequency of the second clock signal. These clock signals determine the rate at which the value of the signals (bytes) to be delivered to the DA-converter by the digital signal generator (e.g. an up/down counter) will increase or decrease. The output signal of the signal comparison device simultaneously controls the clock selection device (selection of the first or the second clock signal) and the digital signal generator (delivering signals with increasing or decreasing values). In this manner the output signal of the signal comparison device controls not only the setting of the clock frequency of the digital signal generator, but also whether the digital signal generator will deliver bytes with increasing values or with decreasing values to the DA-converter. Owing to this it is achieved that, dependent on the (controlling) output signal of the signal comparison device, the digital signal generator will generate either the bytes the value of which increases at the first frequency, which bytes will be converted via the DA-converter into an analog (in discrete steps) increasing first output signal, or the bytes the value of which decreases at the second frequency, which bytes will be converted via the DA-converter into an analog (in discrete steps) decreasing second output signal. It will be understandable that, if the first respectively the second frequency has been set to 0 Hz, the said first respectively second output signal will be constant (as a function of the time).

## C. References

None.

## D. Brief description of the drawings

Figure 1 shows an "integrator"-circuit in accordance with the state of the art.

Figure 2 shows a block diagram of an embodiment of the invention.

Figures 3 and 4 show a graphical representation of the course of the input signal and of the output signal of the device in the case of minima-detection respectively maxima-detection.

Figures 5 and 6 show a quick respectively slow following of the input signal by the output signal in consequence of the different settings of the signal generator.

Figure 7 shows the block diagram of the preferred embodiment of the invention.

Figures 8 and 9 correspond with the figures 3 and 4 and show the course of the input signal and of the output signal of a device in accordance with the preferred embodiment of the invention as shown in figure 7.

## E. Description of the drawings and of the embodiments

Figure 1 shows a known "integrator"-circuit, comprising a diode D and a capacitor C. The input signal A is rectified by the diode D and smoothed by the capacitor C, due to which the output signal B will correspond with the maxima (the peaks) of the (varying) input signal A.

Figure 2 shows a block diagram of an embodiment of the invention, comprising a signal comparison device (comparator) 1, with a first input terminal 2, a second input terminal 3 and an output terminal 4, and a signal generator 5 with an output terminal 6 and a control terminal 7. The control terminal 7 is connected with the output terminal 4 of the signal comparison device 1. The signal generator delivers at its output terminal 6 a signal the instantaneous value of which increases, remains the same or decreases, dependent on the control signal at the control terminal 7. The control signal delivered by the output terminal 4 of the signal comparison device 1 will have for example a fixed positive value, if the instantaneous difference between the signals applied to the first and to the second input terminal is positive, whereas the control signal will have a fixed negative value, if that instantaneous difference is negative. In the case of a positive control signal the signal generator 5 will deliver a signal the (instantaneous) value of which is increasing, in the case of a negative control signal it will deliver a signal the (instantaneous) value of which is decreasing. A (variable) input signal A will now be offered to the first input terminal 2 of the signal comparison device 1, while the output terminal 6 of the signal generator 5 is connected with the second input terminal 3 of the signal comparison device 1. The effect which will be achieved is that as long as the instantaneous value of the input signal A is greater than the instantaneous value of the output signal of the signal generator 5, the latter will deliver an output signal to the input terminal 3 which increases in the time. Because of the fact that either the variable input signal decreases, or the output signal of the signal generator increases quicker than the variable input signal A, the instantaneous difference between the signals at the first respectively second input terminal (2 respectively 3) will become negative at a certain moment, due to which the signal comparison device 1 will deliver a negative control signal to the signal generator 5. After that the signal generator 5 causes its output signal B to decrease, as a result of which at a certain moment this output signal B will be smaller again than the input signal A. At that moment the signal comparison device 1 will once again deliver a positive control signal to the signal generator 5, as a result of which its output signal will increase again.

If the signal generator 5 has been set in such a way that the rate of increase of its output signal B (on reception of a positive control signal) is smaller than the rate of decrease (on reception of a negative control signal), the output signal B of the signal generator 5 will move towards the minima (valleys) of the variable input signal, which is shown by figure 3. This figure 3 also shows the variable input signal A and the output signal B (consisting of an alternation of $B_1$ and $B_2$) of the signal generator 5 (at the same time the output signal of the device). $B_1$ represents the output signal which will be delivered as long as the control signal is positive, $B_2$ represents the output signal when the control signal is negative. The figure shows that the rate of increase of $B_1$ is slow and that the rate of decrease of $B_2$ as a function of the time is high. The result will be that the decreases of the input signal A will be quickly followed, but that the increases will be slowly followed, due to which the output signal will follow the minima of the input signal.

If the signal generator 5 has been set in such a way that the rate of increase of its output signal B (on reception of a positive control signal) is higher than the rate of decrease (on reception of a negative control signal), the output signal B of the signal generator will "climb" to the maxima (peaks) of the variable input signal, which is shown by fig. 4. This figure also shows the variable input signal A and the output signal B - consisting of the parts $B_1$ and $B_2$, which follow each other - of the signal generator 5 (and the device). It can be seen that as long as a positive control signal is given (so as long as the input signal A is larger than the output signal B), the output signal $B_1$ will quickly increase, until it is larger than the input signal A. From that moment the signal generator 5 will deliver, under the control of a negative control signal, a slowly decreasing output signal $B_2$, which will be followed by a quickly increasing output signal $B_1$, as soon as the output signal $B_2$ has become smaller than the input signal A. Because of the fact that the increase of the parts $B_1$ of the output signal B is greater than the decrease of the parts $B_2$, the output signal B will climb to the maxima of the variable input signal A.

It is further remarked that the signal generator 5 can be set in such a way that either $B_1$ or $B_2$ will have a smooth course (will not increase or decrease at all). This setting can be applied when it is desirable to detect the absolute minimum respectively maximum of the input signal A during a long time. If $B_1$ does not show any increase (whereas $B_2$ shows a decrease), the output signal will only be able to decrease (under the influence of the input signal), so that the output signal B will maintain itself on the lowest level of the input signal A. If on the other hand $B_2$ does not increase at all (whereas $B_1$ does increase), the output signal B will maintain itself likewise on the highest level of the input signal A.

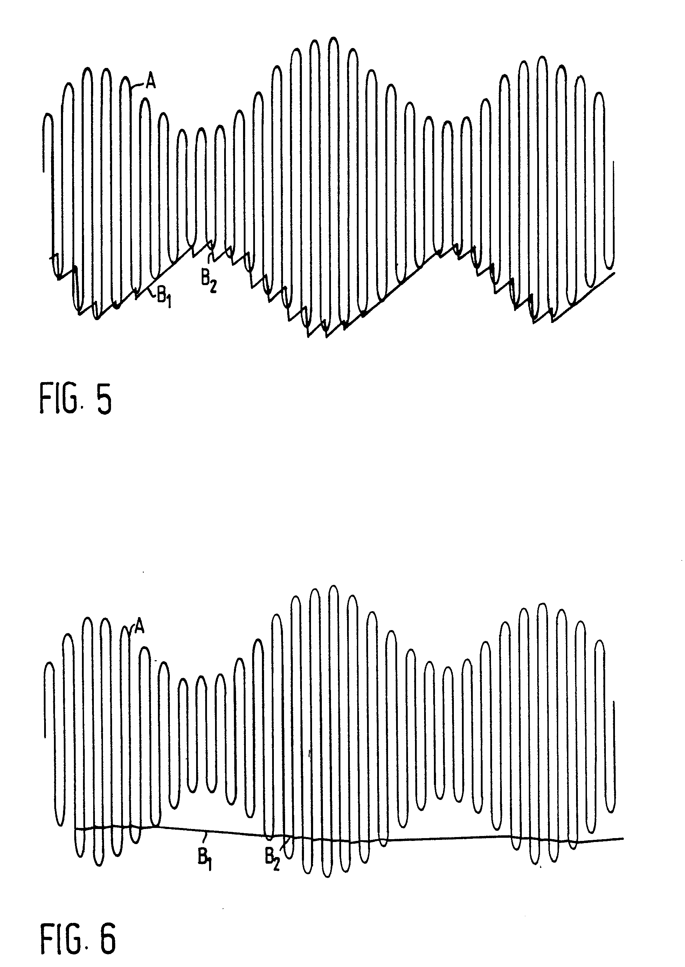

The signal generator 5 can also be set in such a way that both $B_1$ and $B_2$ will relatively quickly increase respectively decrease (in which case the condition remains of course that for following the minima of the input signal A, $B_2$ will decrease more quickly than $B_1$ will increase, and, vice versa, that for following the maxima of the input signal A, $B_1$ will increase more quickly than $B_2$ will decrease). The effect of this is that also in the case of a relatively high variation of frequency of the input signal A, the minima respectively the maxima will be (relatively) quickly followed. If $B_1$ and $B_2$ increase respectively decrease more slowly, the minima respectively the maxima will be followed more slowly. This is shown by way of an example in figures 5 and 6.

Figure 5 shows a rather quickly varying input signal A, the valleys of which are quickly followed by an output signal B, $B_1$ and $B_2$ of which rather quickly increase respectively decrease with the time.

Figure 6 shows the same quickly varying input signal A, the valleys of which are followed considerably slower, compared with the example shown in figure 5, by an output signal B, $B_1$ and $B_2$ of which relatively slowly increase respectively decrease with the time.

It appears from what precedes that quickly or slowly following or even retaining the absolute value of either the minima or the maxima of the input signal A can be set by setting the rate of increse of the fist output signal $B_1$ of the signal generator 5 and the rate of decrease of the second output signal $B_2$.

It is remarked that it is also well possible to let the rate of increase of $B_1$ and the rate of decrease of $B_2$ depend on the greatness of the difference between the input signal A and the output signal B. If desirable a signal comparison device 1 will be of the type with which the output signal (control signal of the signal generator) is for example proportionate to the difference between the two signals (to wit the variable input signal A and the output signal B of the signal generator 5) offered to the first respectively the second input terminal (2 respectively 3). Owing to this the direction in which and the extent to which the instantaneous value of the output signal B varies as a function of the time can be simply related to the sign and the magnitude of the controlling output signal of the signal comparison device.

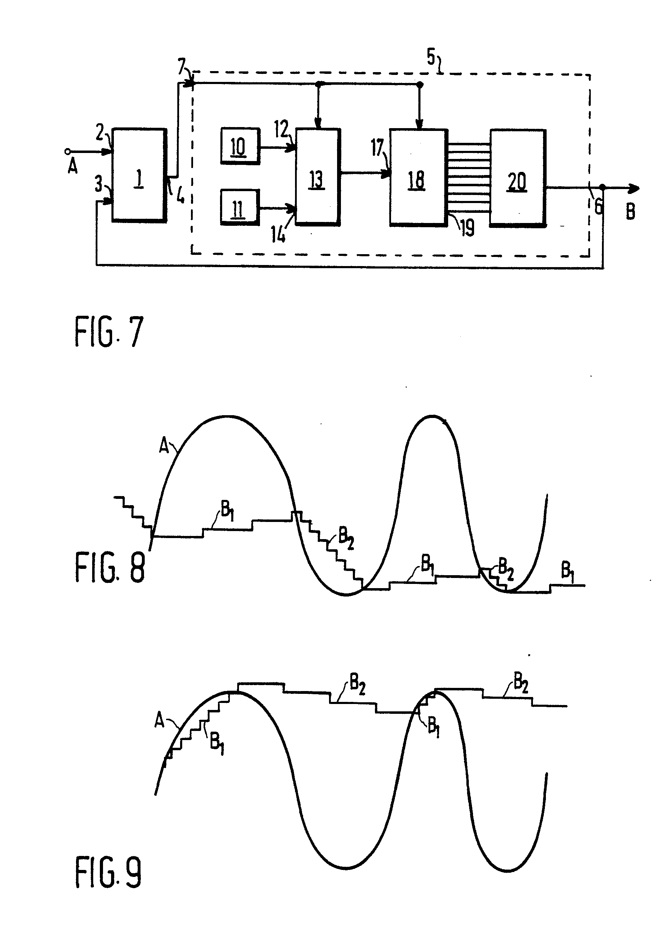

According to a preferred embodiment of the invention the signal generator 5 shown in figure 2 consists of a pair of clock signal generators 10 and 11, shown in figure 7 and capable of delivering their clock signal to a digital up/down counter 18 via a clock selection device 13. Both the clock selection device 13 and the up/down counter 18 are controlled by the output signal of the signal comparison device 1. Thus the value of this output signal (for example a positive or a negative fixed value) effects that the up/down counter either counts up at a first clock frequency, coming from the first clock signal generator 10, or counts down at a second clock frequency, coming from the second clock signal generator 11. The (for example 8-bit) output terminal 19 of the up/down counter is connected with the input terminal of a digital-to-analog converter (DA-converter) 20, which converts the bytes delivered by the up/down counter into a (step-shaped) analog output signal B to the delivered at its output terminal. In this way it is achieved that the up/down counter will count up at the first clock frequency, as soon as and as long as the instantaneous value of the input signal A is greater than that of the output signal B, due to which the output signal B will increase (or, if the first clock frequency is 0 Hz, remain the same) during that time, and that the up/down counter will count down at the second clock frequency, as soon as and as long as the instantaneous value of the output signal B is greater than that of the input signal A, due to which the output signal B will decrease (or, if the second clock frequency is 0 Hz, remain the same) during that time. Consequently, the course in the time (i.e. the average rate of increase respectively decrease) of the first respectively the second output signal $B_1$ respectively $B_2$ depends on the first respectively the second clock frequency, generated by the first clock signal generator 10 respectively the second clock signal generator 11.

Figures 8 and 9 show the course of a variable input signal A, corresponding with that in the figures 3 and 4, as well as the course of the output signal B of the device taken from the output terminal of the DA-converter 20. Compared with the figures 3 and 4, the difference is that the course of the parts $B_1$ and $B_2$ of the output signal is not a smooth one, but that the increase of $B_1$ is caused by a number of increasing discrete steps and that the decrease of $B_2$ is, likewise, caused by a number of decreasing discrete steps. If the frequency of the first clock signal generator 10 is small with regard to that of the second clock signal generator 11, due to which the number of increasing steps per unit of time is small with regard to the number of decreasing steps, the output signal B will move in the direction of the minimum (figure 8). If, on the other hand, the number of increasing steps per unit of time is great with regard to the number of decreasing steps per unit of time, notably because of the fact that the frequency of the first clock signal generator 10 is high with regard to that of the second clock signal generator 11, the output signal B of the device will move towards the maximum (figure 9).

## Claims

1. Device for delivering an output signal corresponding to the maxima or minima of a variable input signal characterized by a signal comparison device (1) and a signal generator (5), which delivers said output signal (B), notably under the control of a control signal, which is taken from an output terminal (4) of the signal comparison device and is a function of the resultant of the comparison of the respective instantaneous values of said variable input signal (A) offered to a first input terminal (2) of the signal comparison device with the output signal (B) of the signal generator fed back to a second input terminal (3) of the signal comparison device, the output signal (B) of the signal generator being formed by a consecutive alternation of a first output signal ($B_1$) with an instantaneous value which, as a function of the time, will not decrease at least on an average, if the output signal (B) of the signal generator is smaller than the variable input signal (A) and a second output signal ($B_2$) with an instantaneous value which, as a function of the time, will not increase at least on an average, if the output signal (B) of the signal generator is larger than the variable input signal (A), the average rate at which the first output signal increases as a function of the time being unequal to the average rate at which the second output signal decreases as a function of the time.

2. Device for delivering an output signal corresponding to the maxima of a variable input signal in accordance with claim 1, characterized in that the average rate at which the first output signal ($B_1$) increases is higher than the average rate at which the second output signal ($B_2$) decreases.

3. Device for delivering an output signal corresponding to the minima of a variable input signal in accordance with claim 1, characterized in that the average rate at which the first output signal ($B_1$) increases is lower than the average rate at which the second output signal ($B_2$) decreases.

4. Device in accordance with claim 1, characterized in that the signal generator (5) comprises a first clock signal generator (10) for delivering a first clock signal at a first frequency to a first input terminal (12) of a clock selection device (13), as well as a second clock signal generator (11) for delivering a second clock signal at a second frequency - unequal to said first frequency - to a second input terminal (14) of said clock selection device;

the clock selection device offering, under the control of the output signal of said signal comparison device (1), either said first clock signal - if the signal at the second input terminal (3) of the signal comparison device is smaller than that at the first input terminal (2) - or said second clock signal - if, on the other hand, the signal at the second input terminal of the signal comparison device is larger than that at the first input terminal - to a clock control terminal (17) of a digital signal generator (18);

which digital signal generator delivers digital signals at its output terminal (19) at a frequency which is proportionate to the clock signal offered to the clock control terminal, the value of which digital signals will either increase under the control of the output signal of said signal comparison device - if the signal at the second input terminal (3) of the signal comparison device is smaller than that at the first input terminal (2) - or decrease - if, on the other hand, the signal at the second input terminal of the signal comparison device is larger than that at the first input terminal;

the output terminal (19) of which digital signal generator is connected with the second input terminal (3) of the signal comparison device via a DA-converting device (20).

5. Device for delivering an output signal corresponding to the maxima of a variable input signal in accordance with claim 4, characterized in that said first frequency is higher than said second frequency.

6. Device for delivering an output signal corresponding to the minima of a variable input signal in accordance with claim 4, characterized in that said first frequency is lower than said second frequency.

FIG. 1

FIG. 2

FIG. 3

FIG. 4

FIG. 5

FIG. 6

FIG. 7

FIG. 8

FIG. 9

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 069 452 (A.W. CONWAY) * Column 3, lines 31-42; column 4, lines 31-52; figures 2,3 * | 1 | G 01 R 19/04 |
| A | ELECTRICAL DESIGN NEWS, vol. 23, no. 4, 20th February 1978, pages 55-57, Denver, US; R. PEPE et al.: "Hunt fast-changing peaks with this high-speed detector" * Page 55, left-hand column, figure 1 * | 1 | |
| A | GB-A-2 136 970 (SOLECTANCHE) * Page 1, lines 29-50,95-125; page 2, lines 1-13 * | 1 | |
| A | RADIO FERNSEHEN ELEKTRONIK, vol. 31, no. 3, March 1982, pages 187-188, Ost-Berlin, DD; K.-H. KURSAWE et al.: "Digitaler Spitzenwertmesser" * Page 187, columns 1,2; figure 1 * | 1 | |

TECHNICAL FIELDS SEARCHED (Int. Cl.4)

G 01 R
H 03 M

The present search report has been drawn up for all claims

| Place of search | Date of completion of the search | Examiner |
|---|---|---|
| THE HAGUE | 22-03-1988 | KUSCHBERT D.E. |